# EUROPÄISCHE PATENTSCHRIFT

(11) **EP 0 452 734 B1**
(45) Veröffentlichungstag und Bekanntmachung des Hinweises auf die Patenterteilung: **16.10.1996**
(21) Anmeldenummer: 91105286.8
(22) Anmeldetag: 03.04.1991
(51) Int. Cl.: H04M 9/10, H03G 3/32

(54) **Freisprecheinrichtung**
Hands free telephone device
Dispositif téléphonique à mains libres

(30) Priorität: 14.04.1990 DE 4012175
(43) Veröffentlichungstag der Anmeldung: 23.10.1991
(73) Patentinhaber: TEMIC TELEFUNKEN microelectronic GmbH, 74072 Heilbronn (DE)
(72) Erfinder: Gutsch, Henrik, Dr., W-7100 Heilbronn (DE)
(74) Vertreter: Maute, Hans-Jürgen, Dipl.-Ing.

(56) Entgegenhaltungen:
- US-A- 4 513 177
- US-A- 4 724 540
- US-A- 4 829 565
- JOURNAL OF THE AUDIO ENGINEERING SOCIETY Bd. 36, Nr. 1-2, Januar 1988, NEW YORK US Seiten 18 - 26 , XP5778 W.J.W. KITZEN ET AL. 'Noise-Dependent Sound Reproduction in a Car: Application of a Digital Audio Signal Processor'

## Beschreibung

Die Erfindung betrifft eine Schaltungsanordnung für eine Freisprecheinrichtung mit einer Sprachsteuerschaltung gemäß dem Oberbegriff des Patentanspruches 1.

Eine solche Schaltungsanordnung ist aus US-A-4 724 540 bekannt.

Ein Freisprechapparat bietet dem Benutzer die Möglichkeit, mit einem anderen Teilnehmer zu sprechen, ohne dabei den Telefonhörer halten zu müssen, da anstelle der Sprech- und Hörkapsel des Handapparates eines üblichen Telefonapparates ein Mikrofon und ein separater Lautsprecher vorhanden sind. Dabei kann das Mikrofon und der Lautsprecher in einem Fernsprechapparat im gleichen Gehäuse untergebracht sein. Ein üblicher Freisprechapparat weist einen Sendesprechweg, einen Empfangssprechweg, eine Schaltungsanordnung zum Verbinden der Zweidrahttellnehmerleitung mit dem Vierdrahtteilnehmerapparat sowie eine Teilnehmerschaltung auf. im allgemeinen ist der Sendesprechweg aus einem Mikrofon, einem Mikrofonverstärker, einem schaltbaren Sendedämpfungsglied und der Sendeteilnehmerleitung aufgebaut, während der Empfangssprechweg aus einem schaltbaren Empfangsdämpfungsglied und einem Ausgangsverstärker besteht, der einen Lautsprecher ansteuert. im Freisprechbetrieb wird der Empfangssprechweg oder der Sendesprechweg in Abhängigkeit von den Amplituden der ankommenden und abgehenden Signale entdämpft. Dies erfolgt mittels einer Sprachsteuerschaltung, die die in den Sprechwegen angeordneten Dämpfungsglieder in Abhängigkeit von den in den Übertragungszweigen festgestellten Sprachpegeln derart ansteuert, daß derjenige Übertragungszweig, der den höheren Sprachpegel aufweist, entdämpft und der andere Übertragungszweig gedämpft wird.

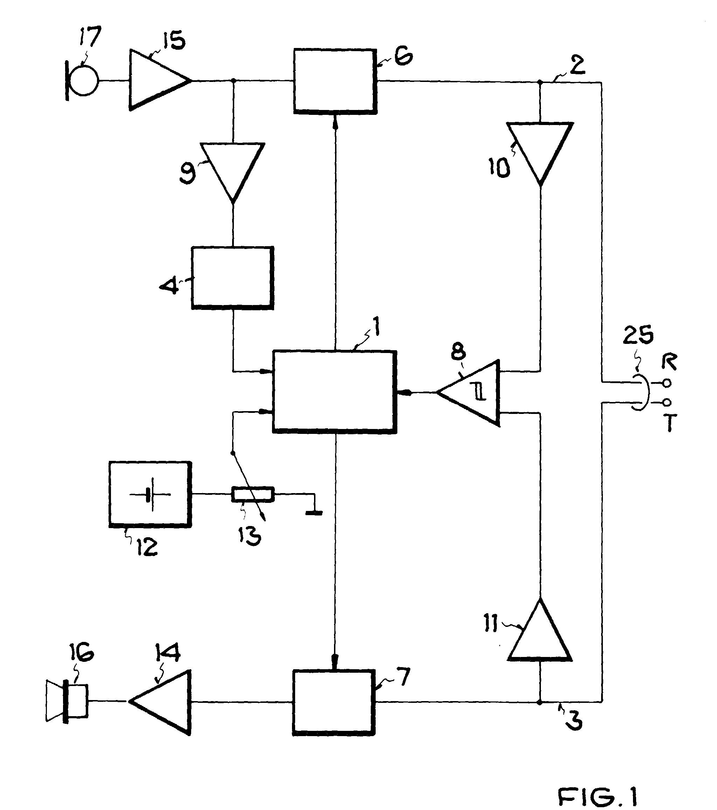

Eine weitere Schaltungsanordnung der eingangs genannten Art, wie sie aus dem Datenbuch "Selection Guide Integrated Circuits" der Fa. TELEFUNKEN electronic, Ausgabe 1990/91, Seite 82, untere Abbildung bekannt ist, zeigt die Figur 1 als vereinfachtes Blockschaltbild. Dort wirkt eine Sprachsteuerschaltung 1 über jeweils eine Leitung auf ein Sendedämpfungsglied 6 bzw. ein Empfangsdämpfungsglied 7 ein. Dem zum Sendesprechweg gehörenden Dämpfungsglied 6 ist ein Mikrofonverstärker 15 sowie ein Mikrofon 17 vorgeschaltet und ist mit seinem Ausgang mit einer Sendeleitung 2 verbunden. Die Eingangssignale werden über eine Empfängerleitung 3 dem Dämpfungsglied 7 zugeführt, dem ein Ausgangsverstärker 14 nachgeschaltet ist, der seinerseits einen Lautsprecher 16 ansteuert. Die Sendeleitung 2 und die Empfängerleitung 3 sind zu einer Teilnehmerleitung 25 mit den Adern R und T zusammengefaßt.

Weiterhin wird sowohl der Sendesignalpegel auf der Sendeleitung 2 über einen logarithmischen Verstärker 10 als auch der Empfangsignalpegel auf der Empfangsleitung 3 über einen logarithmischen Verstärker 11 einem Komparator 8 zugeführt, dessen Ausgang an die Sprachsteuerschaltung 1 angeschlossen ist. Ferner wird das am Ausgang des Mikrofonverstärkers 15 zur Verfügung stehende verstärkte Mikrofonsignal einem Verstärker 9 und einem Sprachdetektor 4 zugeführt, dessen Ausgangssignale ebenfalls an die Sprachsteuerschaltung 1 weitergeleitet werden. Schließlich wird noch der Sprachsteuerschaltung 1 eine einstellbare Steuerspannung zugeführt, die an einem Widerstand 13 abgegriffen wird. Dieser Widerstand 13 ist mit einer Betriebsspannungsquelle 12 für die Schaltungsanordnung verbunden.

Der Sprachdetektor 4 dieser bekannten Schaltungsanordnung hat die Aufgabe, der Sprachsteuerschaltung 1 anzuzeigen, ob gerade gesprochen wird oder ob eine Sprechpause vorliegt. Hierbei ist unter Sprechpause nicht nur die Sprechpause eines Teilnehmers, sondern auch der Sprechwechsel von einem Teilnehmer zum anderen Teilnehmer zu verstehen.

Die beiden Dämpfungsglieder 6 und 7 weisen drei verschiedene stabile Zustände auf:
- Zustand E:: Empfangsweg "Ein" und Sendeweg "Aus"
- Zustand S:: Empfangsweg "Aus" und Sendeweg "Ein"
- Zustand ES:: Beide Dämpfungsglieder 6 und 7 sind in der Mitte zwischen der "Ein"- und der "Aus"-Stellung.

Hierbei ist mit "Ein" eine geringe Dämpfung und mit "Aus" eine hohe Dämpfung des Empfangsweges bzw. des Sendeweges zu verstehen.

Zunächst sei angenommen, daß gesendet wird, wobei kein Empfangssignal auf der Empfängerleitung 3 ansteht, d. h. ein erster Teilnehmer spricht und ein zweiter Teilnehmer hört. Der Sprachdetektor 4 gibt beispielsweise ein H-Pegel aus, der der Sprachsteuerschaltung 1 anzeigt, daß gesprochen wird. Da der Signalpegel auf der Sendeleitung 2 größer ist als auf der Emfängerleitung 3, gibt der Komparator 8 eine Steuerspannung ab, die bewirkt, daß die Sprachsteuerschaltung 1 das Sendedämpfungsglied 6 auf "Ein" und das Empfangsdämpfungsglied 7 auf "Aus" schaltet, entsprechend dem Betriebszustand S.

Tritt nun ein Sprechwechsel ein, verstummt also der erste Teilnehmer und beginnt der zweite Teilnehmer zu sprechen, ändert der Sprachdetektor seinen Ausgangspegel. Die Sprachsteuerschaltung 1 schaltet hierauf die beiden Dämpfungsglieder 6 und 7 auf den Zustand E.

Sprechen jedoch beide Teilnehmer gleichzeitig, gehen die beiden Dämpfungsglieder 6 und 7 in den Betriebszustand ES. Hintergrundgeräusche können ebenfalls bewirken, daß die Sprachsteuerschaltung 1 die beiden Dämpfungsglieder 6 und 7 in den Betriebszustand S schalten. Die bekannte Schaltungsanordnung weist in diesem Fall die Möglichkeit auf, die Dämpfung im Empfangssprechweg über die an dem Widerstand 13 einstellbare Steuerspannung anzuheben, um hierdurch eine Anpassung an den Pegel des Hintergrundgeräusches durch den Teilnehmer vornehmen zu lassen.

Der Nachteil dieser Einstellung der Dämpfung im Empfangssprechweg in Abhängigkeit des Pegels des Hintergrundgeräusches besteht darin, daß sie nur bei länger anhaltenden, kontinuierlichen Hintergrundgeräuschen eine gewisse Anpassung an dieselben erlaubt, jedoch bei kurzfristig auftretenden oder mit hoher Dynamik ausgestatteten Störgeräuschen nicht brauchbar ist, da es für den Teilnehmer sehr umständlich ist, ständig die Dämpfung des Empfangsprechweges einzustellen.

Dieses Problem wird bei einer ebenfalls eine Frelsprechschaltung beschreibende US-A-4 513 177 dadurch gelöst, daß die Hintergrundgeräusche während des Betriebes der Freisprechschaltung aus dem Mikrofonsignal mittels einer Filterschaltung ausgefiltert werden. Die von dieser Filterschaltung gelieferten Filtersignale als auch die in einem Sende- und Empfangszweig erzeugten Signale werden einem A/D-Wandler zugeführt, dessen Digitalsignale von einer Steuereinheit zwecks Ansteuerung von in dem Sende- und dem Empfangszweig angeordneten Dämpfungsgliedern verarbeitet werden.

Der Nachteil dieser Lösung liegt darin, daß die bei Hintergrundgeräuschen auftretenden Frequenzbereiche sich mit Sprachfrequenzbereichen überlappen können und daher der absolute Hintergrundgeräuschpegel mit dieser bekannten Schaltung nicht erfaßbar ist.

Eine andere Lösung dieses Problems kennt der Fachmann aus der US-A-4 829 565, wo zur Erfassung des Hintergrundpegels ein weiterer Sensor zusätzlich zum Mikrofon eingesetzt wird. Eine solche Lösung kann daher nicht bei handelsüblichen Handapparaten verwendet werden, da sie nicht für die Aufnahme eines weiteren Sensors vorgesehen sind und eine Nachrüstung daher nicht möglich ist.

Der Erfindung liegt daher die Aufgabe zugrunde, eine Schaltungsanordnung der eingangs genannten Art zu schaffen, die den Einfluß sich stark ändernder Pegel von Hintergrundgeräuschen auf den Freisprechbetrieb vermindert.

Diese Aufgabe wird durch die im kennzeichnenden Teil des Patentanspruches 1 angegebenen Merkmale gelöst.

Die Erfindung nutzt zur Lautstärkeeinstellung den Sprachdetektor, der eine Geräuschpegelmeßschaltung ansteuert, in dem diese genau dann den Pegel des Hintergrundgeräusches mißt, wenn der Sprachdetektor eine Sprechpause anzeigt. In Abhängigkeit der Höhe des gemessenen Hintergrundgeräuschpegels wird durch die Geräuschpegelmeßschaltung der Sende- und Empfangssprechweg entdämpft, d. h., nimmt der Pegel des Hintergrundgeräusches zu, wachsen entsprechend die Amplituden des Empfangssignales im Lautsprecher als auch diejenigen des Sendesignales. Ist dagegen kein Hintergrundgeräusch feststellbar, arbeitet diese erfindungsgemäße Schaltung mit minimalen Pegeln auf der Empfangs- und Sendeseite. Damit werden Hintergrundgeräusche, wie z. B. das Geräusch von Lüftern, Kühlaggregaten, Schreibmaschinen aber auch Verkehrslärm, der eine hohe Dynamik aufweisen kann, oder nur kurzzeitig auftretende Geräusche ihrer Wirkung auf die Sprachsteuerung beraubt, ohne daß der Teilnehmer irgendwelche Einstellungen am Freisprechapparat vorzunehmen hat. Die Anpassung der Sende- und Empfangspegel an die Höhe des Hintergrundgeräuschpegels erfolgt somit vollständig automatisch.

Ausgestaltungen der erfindungsgemäßen Schaltungsanordnung sind den Unteransprüchen 2 und 3 zu entnehmen. Gemäß Anspruch 4 sind zur Verstärkung der Sende- und Empfangssignale entsprechend der Höhe des Hintergrundgeräuschpegels spannungsgesteuerte Verstärker vorgesehen, deren Verstärkungsfaktor durch die Geräuschpegelmeßschaltung gesteuert werden. Schließlich ist bei einer weiteren vorteilhaften Weiterbildung der Erfindung gemäß Anspruch 5 ein NOR-Glied zum Ein- bzw. Ausschalten der Geräuschpegelmeßschaltung vorgesehen.

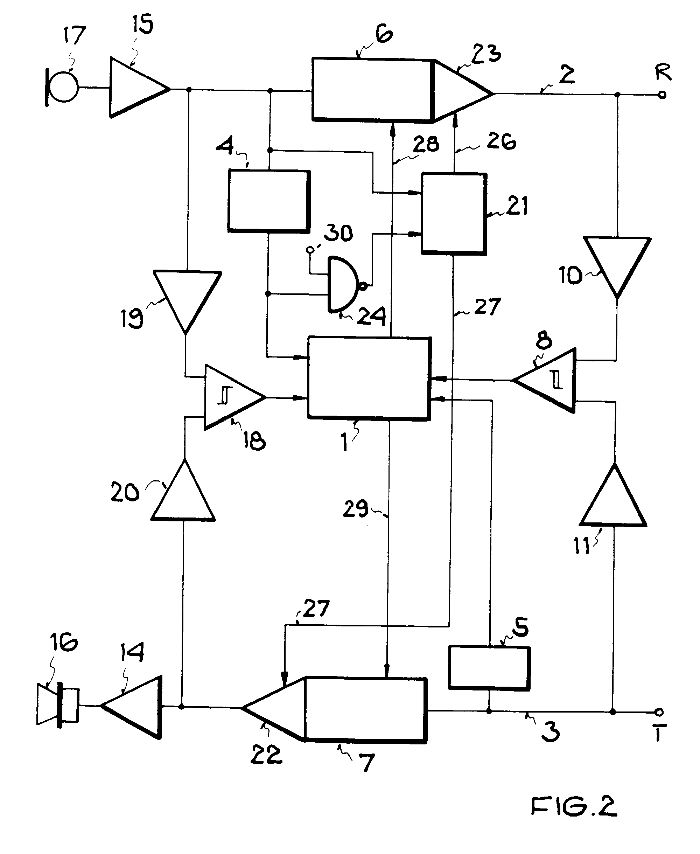

Nachfolgend soll ein Ausführungsbeispiel der erfindungsgemäßen Schaltungsanordnung im Zusammenhang mit der Figur 2 erläutert werden.

Die Figur 2 zeigt ein Blockschaltbild des Ausführungsbeispieles.

Die Freisprecheinrichtung gemäß der Figur 2 besteht aus einem Sendesprechweg, der aus einem Mikrofon 17, einem Mikrofonverstärker 15, einem Sendedämpfungsglied 6, einem spannungsgesteuerten Verstärker 23 sowie einer Sendeleitung 2, die die R-Ader der Teilnehmerleitung darstellt, aufgebaut. Die Sprachsignale des Teilnehmers gelangen zusammen mit den Hintergrundgeräuschen auf das Mikrofon 17, das sie in elektrische Signale umsetzt. Vom Ausgang dieses Mikrofons 17 gelangen die gewandelten Sprachsignale über den Mikrofonverstärker 15, sowohl zu dem Sendedämpfungsglied 6 als auch zu einem logarithmischen Verstärker 19, einem Sprachdetektor 4 und einer Geräuschpegelmeßschaltung 21. Dem Sendedämpfungsglied 6 ist der Verstärker 23 nachgeschaltet, der seinerseits mit der Sendeleitung 2 und einem logarithmischen Verstärker 10 verbunden ist. Der Empfängersprechweg besteht in entsprechender Weise aus einem Lautsprecher 16, einem Ausgangsverstärker 14, einem spannungsgesteuerten Verstärker 22, einem Empfängerdämpfungsglied 7 sowie einer Empfängerleitung 3, die die T-Ader der Teilnehmerleitung darstellt. Ein Empfangssignal gelangt über die Empfängerleitung 3 sowohl auf das Empfangsdämpfungsglied 7 als auch auf einen weiteren Sprachdetektor 5 und einen Verstärker 11. Die Ausgangssignale des Verstärkers 10 und des Verstärkers 11 werden auf die Eingänge eines Komparators 8 geführt, dessen Ausgang mit einer Sprachsteuerschaltung 1 verbunden ist. Die Ausgangssignale des zweiten Sprachdetektors 5 werden ebenfalls dieser Sprachsteuerschaltung 1 zugeführt. Dem Empfangsdämpfungsglied 7 ist der Verstärker 22 nachgeschaltet, dessen Ausgangssignale sowohl einem Ausgangsverstärker 14 als auch einem Verstärker 20 zugeführt werden. Der Ausgangsverstärker 14 steuert schließlich den Lautsprecher 16 an. Die Ausgangssignale der Verstärker 19 und 20 werden einem weiteren Komparator 18 zugeführt, dessen Ausgang ebenfalls mit der Sprachsteuerschaltung 1 verbunden ist. Schließlich werden auch die Ausgangssignale des ersten Sprachdetektors 4 dieser Sprachsteuerschaltung 1 zugeführt. Die gleichen Ausgangssignale werde einem Eingang eines NOR-Gliedes 24 zugeführt, dessen Ausgang die Geräuschpegelmeßschaltung 21 ansteuert. Zum Ein- bzw. Ausschalten der Geräuschpegelmeßschaltung 21 kann einem zweiten Eingang 30 des NOR-Gliedes 24 ein Schaltsignal zugeführt werden. Die Geräuschpegelmeßschaltung 21 steuert über eine Steuerleitung 26 den Verstärkungsgrad des Verstärkers 23 und über eine weitere Steuerleitung 27 den Verstärkungsgrad des Verstärkers 22, wogegen die Dämpfung des Sendedämpfungsgliedes 6 über eine von der Sprachsteuerschaltung 1 ausgehenden Steuerleitung 28 und diejenige des Empfangsdämpfungsgliedes 7 über eine ebenfalls von der Sprachsteuerschaltung 1 ausgehenden weiteren Steuerleitung 29 eingestellt werden.

Die Funktion dieser Freisprechschaltung bezüglich den beiden logarithmischen Verstärkern 10 und 11, dem zugehörigen Komparator 8, dem ersten Sprachdetektor 4 und der Sprachsteuerschaltung 1 entspricht der Freisprechschaltung gemäß der schon eingangs beschriebenen Figur 1, nämlich die Sende- und Empfangspegel auf den Leitungen 2 und 3 sowie die Sprechpausen des einen Teilnehmers zu detektieren, um hieraus mit Hilfe der Sprachsteuerschaltung 1 die entsprechenden Dämpfungswerte an den Dämpfungsgliedern 6 und 7 einstellen zu können. Die beiden weiteren logarithmischen Verstärker 19 und 20, die die Pegel des verstärkten Sprachsignales des einen Teilnehmers bzw. die Pegel des dem Ausgangsverstärkers 14 zugeführten Sprachsignale des anderen Teilnehmers detektieren, der zugehörige zweite Komparator 8 und der zweite Sprachdetektor 5, der die Sprechpausen des anderen Teilnehmers festellt, dienen einer verbesserten Dämpfungssteuerung um somit den Teilnehmern den Eindruck einer natürlichen Konversation zu vermitteln.

Erfindungsgemäß werden die am Ausgang des Mikrofonverstärkers 15 anliegenden verstärkten Sprachsignale sowie die Ausgangssignale des ersten Sprachdetektors 4 zur Messung des Hintergrundgeräuschpegels herangezogen. Die Zeitpunkte, zu denen diese Messung durch die Geräuschpegelmeßschaltung 21 erfolgt, werden durch den Sprachdetektor 4 bestimmt, nämlich genau dann, wenn er eine Sprechpause detektiert. Beispielsweise bedeutet ein H-Pegel an dessen Ausgang, daß auf dem Sendesprechweg gerade gesprochen wird, während ein L-Pegel am Ausgang des Sprachdetektors 4 eine augenblickliche Sprechpause anzeigt. Die Geräuschpegelmeßschaltung 21 mißt also den am Mikrofon 17 auftretenden Geräuschpegel nur dann, wenn der Sprachdetektor 4 einen L-Pegel ausgibt. Zur Steuerung der beiden spannungsgesteuerten Verstärker 22 und 23 erzeugt die Geräuschpegelmeßschaltung 21 ein DC-Signal, dessen Wert dem am Mikrofon 17 vorhandenen Geräuschpegel proportional ist. Hierdurch werden die Sende- und Empfangssignale so verstärkt, daß eine entsprechende Kompensation der Hintergrundgeräusche erfolgt.

Diese erfindungsgemäße Freisprechschaltung mit einer automatischen Hintergrundgeräuschkompensation erfordert nur wenig zusätzlichen Schaltungsaufwand gegenüber einer bekannten Freisprechschaltung, beispielsweise gemäß der Figur 1, da zur Hintergrundgeräuschkompensation zusätzlich die Ausgangssignale des Mikrofonverstärkers und des Sprachdetektors genutzt werden. Hierdurch ist auch eine wirtschaftliche Herstellung eines solchen Freisprechschaltkreises sichergestellt.

Die erfindungsgemäße Schaltungsanordnung kann nicht nur in analoger sonder auch in digitaler Form aufgebaut werden. Die Geräuschpegelmeßschaltung kann man verschiedenartig realisieren, beispielsweise mit einem Spitzen-Detektor, einer Abtast- und Halteschaltung oder mit einer Integrationsschaltung. Die Steuerung der beiden spannungsgesteuerten Verstärker 22 und 23 kann klassisch mit einem AGC-Signal erfolgen oder mit Hilfe von Multiplikationsschaltungen durchgeführt werden.

## Patentansprüche

1. Schaltungsanordnung für eine Freisprecheinrichtung mit einer Sprachsteuerschaltung (1), die in Abhängigkeit der Signalpegel auf einer Sendeleitung (2) und einer Empfängerleitung (3) sowie in Abhängigkeit der Ausgangssignale eines Sprachdetektors (4) jeweils eine in der Sendeleitung (2) und der Empfängerleitung (3) vorgesehene Dämpfungsschaltung (6, 7) ansteuert, wobei der Sprachdetektor (4) mit einem Mikrofon (17) verbunden ist, gekennzeichnet durch folgende Merkmale.
(a) daß eine Geräuschpegelmeßschaltung (21) vorgesehen ist,
(b) daß diese Geräuschpegelmeßschaltung (21) sowohl mit dem Ausgang des Sprachdetektors (4) als auch mit dem Mikrofon (17) verbunden ist,
(c) daß weiterhin Schaltungsmittel (22, 23) zur Verstärkung der Sende- und Empfangssignale vorgesehen sind,
(d) daß die Geräuschpegelmeßschaltung (21) diese Schaltungsmittel (22, 23) in Abhängigkeit des in den Sprechpausen am Mikrofon (17) auftretenden Hintergrundgeräuschpegels derart ansteuert, daß die Sende- und Empfangssignalpegel bei zunehmendem Hintergrundgeräuschpegel erhöht werden und umgekehrt bei abnehmendem Hintergrundgeräuschpegel erniedrigt werden.

2. Schaltungsanordnung nach Anspruch 1, dadurch gekennzeichnet, daß der Sprachdetektor (4) als auch die Geräuschpegelmeßschaltung (21) über einen Mikrofonverstärker (15) mit dem Mikrofon (17) verbunden sind.

3. Schaltungsanordnung nach Anspruch 1 oder 2, dadurch gekennzeichnet, daß die Schaltungsmittel (22, 23) zur Verstärkung der Sende- und Empfangssignale jeweils an den Ausgang der Dämpfungsschaltungen (6, 7) angeschlossen sind.

4. Schaltungsanordnung nach einem der vorangehenden Ansprüche, dadurch gekennzeichnet, daß die Schaltungsmittel (22, 23) zur Verstärkung der Sende- und Empfangssignale spannungsgesteuerte Verstärker darstellen.

5. Schaltungsanordnung nach einem der vorangehenden Ansprüche, dadurch gekennzeichnet, daß zwischen dem Ausgang des Sprachdetektors (4) und der Geräuschpegelmeßschaltung (21) ein NOR-Glied (24) mit zwei Eingängen geschaltet ist, daß der erste Eingang des NOR-Gliedes (24) an den Ausgang des Sprachdetektors (4) angeschlossen ist, daß zum Ein- bzw. Ausschalten der Geräuschpegelmeßschaltung (21) über den zweiten Eingang des NOR-Gliedes (24) ein Schaltsignal zugeführt wird und daß der Ausgang des NOR-Gliedes (24) an die Geräuschpegelmeßschaltung (21) angeschlossen ist.

## Claims

1. Circuit arrangement for a hands-free equipment including a speech control circuit (1) that controls a respective attenuating circuit (6, 7) provided in a transmit lead (2) and a receive lead (3) in dependence on the signal level on the transmit lead (2) and the receive lead (3) and also in dependence on the output signals of a speech detector (4), wherein the speech detector (4) is connected to a microphone (17), characterised by the following features:
(a) that there is provided a noise level measuring circuit (21),
(b) that this noise level measuring circuit (21) is connected to both the output of the speech detector (4) and to the microphone (17),
(c) that furthermore, circuit means (22, 23) for amplifying the transmit and receive signals are provided,
(d) that the noise level measuring circuit (21) controls these circuit means (22, 23) in dependence on the background noise level occurring in the pauses in speech at the microphone (17) in such a way that the transmit and receive signal levels are increased when the background noise level is increasing and, conversely, are decreased when the background noise level is decreasing.

2. Circuit arrangement in accordance with Claim 1, characterised in that, the speech detector (4) and also the noise level measuring circuit (21) are connected via a microphone amplifier (15) to the microphone (17).

3. Circuit arrangement in accordance with Claim 1 or 2, characterised in that, the circuit means (22, 23) for amplifying the transmit and receive signals are respectively connected to the output of the attenuating circuits (6, 7).

4. Circuit arrangement in accordance with any of the preceding Claims, characterised in that, the circuit means (22, 23) for amplifying the transmit and receive signals are voltage controlled amplifiers.

5. Circuit arrangement in accordance with any of the preceding Claims, characterised in that, a NOR gate means (24) having two inputs is connected between the output of the speech detector (4) and the noise level measuring circuit (21), that the first input of the NOR gate means (24) is connected to the output of the speech detector (4), that a switching signal is supplied via the second input of the NOR gate means (24) for the purposes of switching the noise level measuring circuit (21) on and off and that the output of the NOR gate means (24) is connected to the noise level measuring circuit (21).

## Revendications

1. Montage pour un dispositif mains libres, comprenant un circuit de commande vocale (1) qui, en fonction des niveaux de signal sur une ligne d'émission (2) et une ligne de réception (3), ainsi qu'en fonction des signaux de sortie d'un détecteur de voix (4), pilote des circuits d'atténuation (6, 7) prévus respectivement dans la ligne d'émission (2) et la ligne de réception (3), le détecteur de voix (4) étant relié à un microphone (17), caractérisé en ce que:
a) il comprend un circuit de mesure de niveau de bruit (21),
b) ce circuit de mesure de niveau de bruit (21) est relié à la fois à la sortie du détecteur de voix (4) et au microphone (17),
c) il comprend en outre des moyens de couplage (22, 23) pour amplifier les signaux d'émission et de réception et
d) le circuit de mesure de niveau de bruit (21) pilote ces moyens de couplage (22, 23) en fonction du niveau de bruit de fond apparaissant lors des intervalles dans la conversation au microphone (17), de manière que les niveaux de signal d'émission et de réception soient relevés quand le niveau de bruit de fond augmente et que, inversement, ces niveaux soient abaissés quand le niveau de bruit de fond diminue.

2. Montage selon la revendication 1, caractérisé en ce que le détecteur de voix (4) et le circuit de mesure de niveau de bruit (21) sont reliés tous deux à travers un amplificateur de microphone (15) au microphone (17).

3. Montage selon la revendication 1 ou 2, caractérisé en ce que les moyens de couplage (22, 23) pour amplifier les signaux d'émission et de réception sont raccordés respectivement aux sorties des circuits d'atténuation (6, 7).

4. Montage selon une des revendications précédentes, caractérisé en ce que les moyens de couplage (22, 23) pour amplifier les signaux d'émission et de réception représentent des amplificateurs commandés par tension.

5. Montage selon une des revendications précédentes, caractérisé en ce qu'un élément NON-OU (24) à deux entrées est connecté entre la sortie du détecteur de voix (4) et le circuit de mesure de niveau de bruit (21), que la première entrée de l'élément NON-OU (24) est connectée à la sortie du détecteur de voix (4), qu'un signal de commutation est appliqué à travers la seconde entrée de l'élément NON-OU (24) pour activer ou désactiver le circuit de mesure de niveau de bruit (21) et que la sortie de l'élément NON-OU (24) est connectée au circuit de mesure de niveau de bruit (21).
